# FASCICULE DE BREVET EUROPEEN

(11) **EP 3 270 515 B1**
(45) Date de publication et mention de la délivrance du brevet: **29.09.2021**
(21) Numéro de dépôt: 17180986.6
(22) Date de dépôt: 12.07.2017
(51) Int. Cl.: H03K 17/691, H03K 17/10, H03K 17/12

(54) **COMMUTATEUR ULTRA-RAPIDE À HAUTE TENSION**
EXTREM SCHNELLER HOCHSPANNUNGSSCHALTER
HIGH-VOLTAGE HIGH-SPEED SWITCH

(30) Priorité: 13.07.2016 FR 1656746
(43) Date de publication de la demande: 17.01.2018
(73) Titulaire: COMECA POWER, 72100 Le Mans (FR)
(72) Inventeur: MILLY, Roger, 38290 SATOLAS ET BONCE (FR); ESPENEL, Philippe, 38090 VAULX MILIEU (FR); RAULET, Claude, 69580 SATHONAY VILLAGE (FR)
(74) Mandataire: Gevers & Orès

(56) Documents cités:
- WO-A1-90/13178
- FR-A1- 2 821 215
- JP-A- 2013 150 454
- US-A1- 2016 013 655

## Description

### DOMAINE TECHNIQUE

La présente invention concerne un commutateur ultra-rapide à haute tension.

### ÉTAT DE LA TECHNIQUE

La présente invention concerne un commutateur ultra rapide haute-tension réalisée par mise en matrice de transistors de puissance.

De tels commutateurs sont utilisés comme générateurs d'impulsions haute tension (de quelques kilovolts à une centaine de kilovolts) ultra rapide (temps de commutation de l'ordre de quelques nanosecondes) et à fréquence de récurrence élevée (jusqu'à plusieurs centaines de kilohertz).

Ces commutateurs ou interrupteurs trouvent leurs applications dans les domaines des alimentations pulsées, les lasers, les plasmas, la décontamination bactérienne par champ électrique pulsé.

Le document FR 2178904 décrit un commutateur rapide de haute tension à amplificateur d'impulsions comprenant une commande isolée utilisant trois transformateurs constitués par des tores de ferrite traversés par des câbles haute tension.

Le document EP 0724332 décrit un dispositif de commutation d'un circuit de haute tension à transformateurs d'impulsions pour très hautes tensions.

Le document EP 0782266 décrit un commutateur impulsionnel de puissance capable de fournir des impulsions de courant de forte intensité et de faible durée. Le commutateur porte sur un principe de commande permettant une commutation très rapide des matrices de transistors MOS
(« Metal Oxyde Semiconductor » pour semi-conducteur à oxyde métallique en anglais) à la fermeture et à l'ouverture.

Le document EP 0716507 décrit un dispositif de commande d'un commutateur à grille isolée, de fort courant, et un commutateur d'impulsions comportant un tel dispositif.

Le document EP 0880228 décrit un interrupteur rapide, capable de supporter une tension et un courant direct élevés, obtenu par un assemblage de thyristors élémentaires. L'interrupteur permet de réaliser des cartes interrupteurs électroniques constituées d'une matrice de thyristors.

Le document EP 0887929 décrit un commutateur ultra-rapide, à haute fréquence de récurrence à base de matrice à transistors MOSFET (« Metal Oxide Semiconductor Field Effect Transistor » en anglais pour transistor à effet de champ à grille isolée).

Le document JP 2013-150454 décrit un dispositif de conversion de puissance, capable de convertir une puissance fournie en une puissance motrice pour un moteur.

Le document FR 2821215 décrit un dispositif de commande d'un commutateur à grille isolée de fort et très fort courant et un commutateur à commutation rapide comportant un tel dispositif.

Cependant, aucune des solutions ci-dessus ne permet d'avoir des temps de commande assez longs pour maintenir enclenchés de façon fiable les transistors de puissance.

### EXPOSÉ DE L'INVENTION

La présente invention a pour objet de pallier cet inconvénient en proposant un commutateur susceptible de supporter de très hautes tensions (de quelques kilovolts à quelques centaines de kilovolts) et qui est susceptible de se fermer et de s'ouvrir très rapidement (temps de fermeture et d'ouverture compris entre quelques nanosecondes et quelques dizaines de nanosecondes) pour fournir des impulsions de courant de forte intensité (de centaines d'ampères à plusieurs milliers) de façon fiable.

À cet effet, l'invention concerne un commutateur ultra-rapide à haute tension tel que défini par la revendication indépendante 1. Les modes particuliers de réalisation sont définis dans les revendications dépendantes.

Ainsi, grâce à l'invention, il est possible d'obtenir un commutateur qui supporte de très hautes tensions et qui est susceptible de se fermer et de s'ouvrir très rapidement pour fournir des impulsions de courant de forte intensité de façon fiable.

### BRÈVE DESCRIPTION DES FIGURES

L'invention, avec ses caractéristiques et avantages, ressortira plus clairement à la lecture de la description faite en référence aux dessins annexés dans lesquels :
- la figure 1 correspond à une représentation schématique d'un mode de réalisation du circuit du commutateur mettant en évidence la matrice de transistors de puissance ;
- la figure 2 représente un mode de réalisation du commutateur ;
- les figures 3, 4 et 5 représentent trois modes de réalisation d'un détail du transformateur d'impulsion ;
- la figure 6 illustre un exemple de circuit électronique comprenant un tore de ferrite ;
- la figure 7 représente une configuration d'une carte électronique du commutateur ;
- les figures 8 et 9 illustrent deux modes de réalisation du commutateur ;
- la figure 10 représente le commutateur selon un mode de réalisation pour lequel les signaux de commande sont envoyés à partir d'une carte driver ;
- la figure 11 représente un schéma du circuit du commutateur selon un mode de réalisation.

### DESCRIPTION DÉTAILLÉE

La suite de la description fera référence aux figures citées ci-dessus.

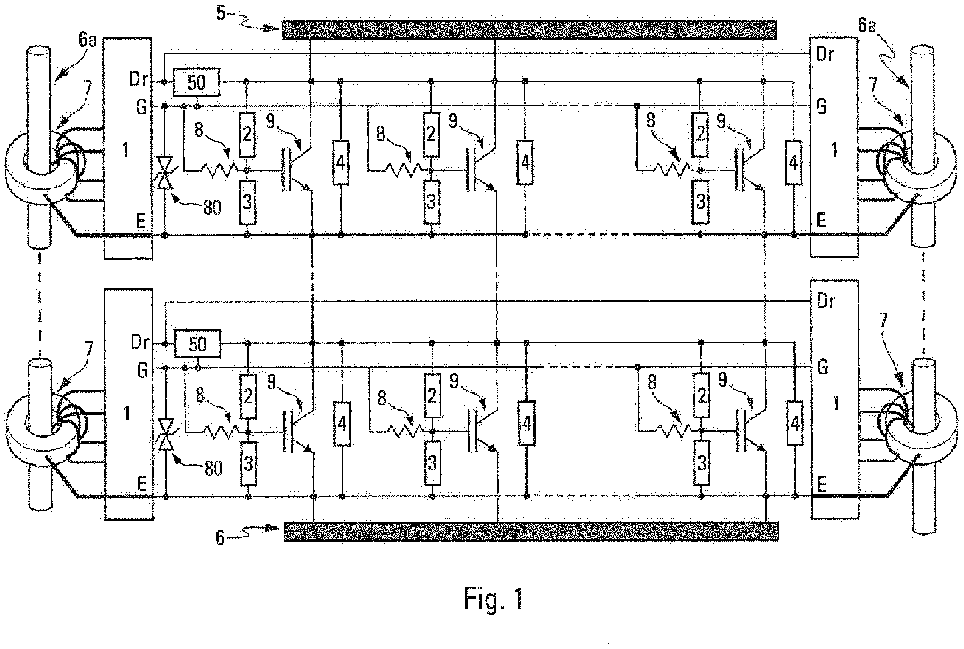

La figure 1 illustre un mode de réalisation du commutateur.

Le commutateur comprend une matrice de composants à grille isolée. Les composants à grille isolée correspondent, par exemple, à des transistors à effet de champ à grille métal-oxyde (MOSFET pour « Metal Oxide Semiconductor Field Effect Transistor » en anglais) et/ou des transistors bipolaires à grille isolée (IGBT pour « Insulated Gate Bipolar Transistor » en anglais) et/ou des transistors MOSFET à carbure de silicium (SIC-MOSFET pour « Silicone Carbide Metal Oxide Semiconductor Field Effect transistor » en anglais) et/ou des transistors à effet de champ à nitrure de gallium (GaN-FET pour « Gallium Nitride Field Effect transistor » en anglais).

Par simplification, dans les figures, nous adopterons la représentation d'un IGBT pour la représentation de n'importe quel type de composant à grille isolée.

Les composants utilisés sont des composants les plus standards qui possèdent les avantages d'être peu chers, très faciles à approvisionner. Le processus de fabrication des composants à forte diffusion commerciale permet d'avoir des performances sur ces composants les plus reproductibles.

Les boîtiers de ces composants de puissance sont de type TO220, TO247, SUPER220... pour des composants traversants, ou des boîtiers de type D2pack, TO263... mais tout type de boîtier peut être envisagé. Le boîtier participe à la dissipation des pertes du composant de puissance. Si les pertes en Joule sont importantes (pour des fréquences élevées par exemple), le commutateur pourra être placé dans un bain d'huile afin d'optimiser les échanges de chaleur.

Un refroidissement dans l'huile permet d'avoir une homogénéisation de la température sur l'ensemble des composants, ce qui augmente la fiabilité. Dans le cas de la haute tension, l'utilisation de l'huile permet de réduire les distances d'isolement et donc de minimiser les volumes du système.

Pour des pertes Joule plus faibles, une dissipation dans l'air peut être suffisante.

La commande de ces transistors s'effectue via un unique câble de commande. Ce câble 6a de type haute tension (isolant de forte épaisseur) permet de tenir la tension d'isolement entre un circuit primaire 6a et un circuit secondaire 20, 27, mais aussi de minimiser la capacité parasite entre le circuit primaire 6a et le circuit secondaire 20, 27.

Pour des raisons de fiabilité à la fermeture ou à l'ouverture du commutateur, le système de commande pourra être mis en redondance. En effet dans le cas d'une utilisation en court-circuiteur sur une ligne haute-tension DC à protéger, il faut être sûr de la fermeture du commutateur ; dans ce cas-là une commande redondante est recommandée.

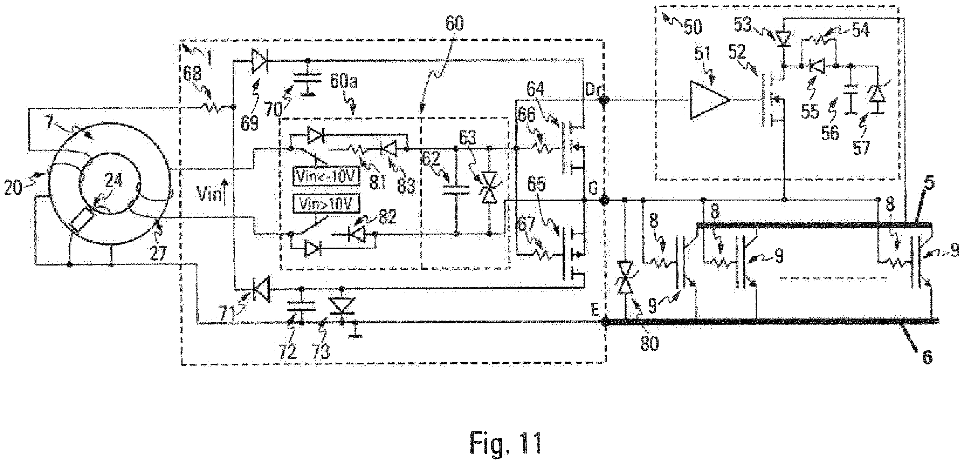

Le commutateur ultra-rapide à haute tension comprend :
- au moins une matrice de transistors de puissance à grille isolée 9 contenant au moins une rangée de transistors de puissance 9 montés en parallèle (figure 1) ou au moins une colonne de transistors de puissance (9) montés en série,
- pour chaque rangée de transistors de puissance 9, un premier dispositif de commande 1 étant connecté à une extrémité de la rangée de transistors de puissance 9, le premier dispositif de commande 1 étant aptes à commander les transistors de puissance 9,
- pour chaque premier dispositif de commande 1, au moins un transformateur d'impulsion comprenant un circuit primaire 6a de commande apte à émettre une commande, un premier circuit secondaire 20 et un deuxième circuit secondaire 27 (figure 11),
- un module de renforcement de la commande 50 apte à renforcer la commande émise par le circuit primaire 6a par l'intermédiaire du deuxième circuit secondaire 27.

Chacun des transistors de puissance 9 présente une borne drain, une borne source et une borne grille.

Par exemple, comme représenté sur la figure 11, le module de renforcement 50 pilote les transistors de puissance 9 en utilisant une tension présente entre la borne drain et la borne source de chacun des transistors de puissance 9.

Le ou les premiers dispositifs de commande 1 comprennent un module de mémorisation de la commande 60 apte à mémoriser la commande émise par le circuit primaire 6a par l'intermédiaire du deuxième circuit secondaire 27.

Par exemple, comme représenté sur la figure 11, le premier circuit secondaire 20 fournit l'énergie nécessaire au fonctionnement d'un étage d'amplification 64, 65 du premier dispositif de commande 1. L'étage d'amplification 64, 65 est présent entre le module de mémorisation 60 et les transistors de puissance 9.

Selon une variante, le premier dispositif de commande 1 est connecté à une extrémité de la rangée.

Selon une autre variante, le premier dispositif de commande 1 est connecté dans une région centrale de la rangée entre deux transistors de puissance 9.

Selon un mode de réalisation, le commutateur peut comprendre en outre :
- pour chaque rangée de transistors de puissance 9, un deuxième dispositif de commande 1 connecté à la rangée de transistors de puissance 9, le deuxième dispositif de commande 1 étant apte à commander les transistors de puissance 9,
- pour chaque deuxième dispositif de commande 1, au moins un transformateur d'impulsion comprenant un circuit primaire 6a de commande apte à émettre une commande, un premier circuit secondaire 20 et un deuxième circuit secondaire 27,
- pour chaque deuxième dispositif de commande 1 au moins un module de renforcement de la commande 50 et un module de mémorisation 60 apte à mémoriser la commande émise par le circuit primaire 6a par l'intermédiaire du deuxième circuit secondaire 27.

De la même manière que le premier dispositif de commande 1, selon une variante, le deuxième dispositif de commande 1 est connecté à une extrémité de la rangée.

Selon une autre variante, le deuxième dispositif de commande 1 est connecté dans une région centrale de la rangée entre deux transistors de puissance 9.

La matrice de transistors de puissance 9 peut être agencée en modules de puissance sur des cartes électroniques 11 afin d'obtenir une modularité de la matrice. Cet aspect modulaire par carte électronique permet par leurs agencements une réduction significative de l'inductance série du commutateur. De plus, un module peut lui-même être mis sous forme matricielle afin de répondre aux besoins d'un commutateur en tension et en courant. Cette modularité permet aussi un montage dit en « accordéon » des cartes électroniques 11 permettant une réduction de l'inductance série du commutateur et donc d'avoir des fronts de montées plus rapides sur le courant. Cette disposition en accordéon permet d'avoir une longueur du commutateur réduite par rapport à une mise en ligne des modules.

L'aspect modulaire permet de définir un commutateur haute-tension (par exemple, un commutateur fournissant une tension de 10 kV et un courant de 2 kA) de base qui pourra être assemblé en matrice afin d'obtenir un commutateur répondant aux exigences de tension et courant d'une application (par exemple, un commutateur fournissant une tension de 40 kV et un courant de 2 kA par la mise en série de quatre commutateurs de base).

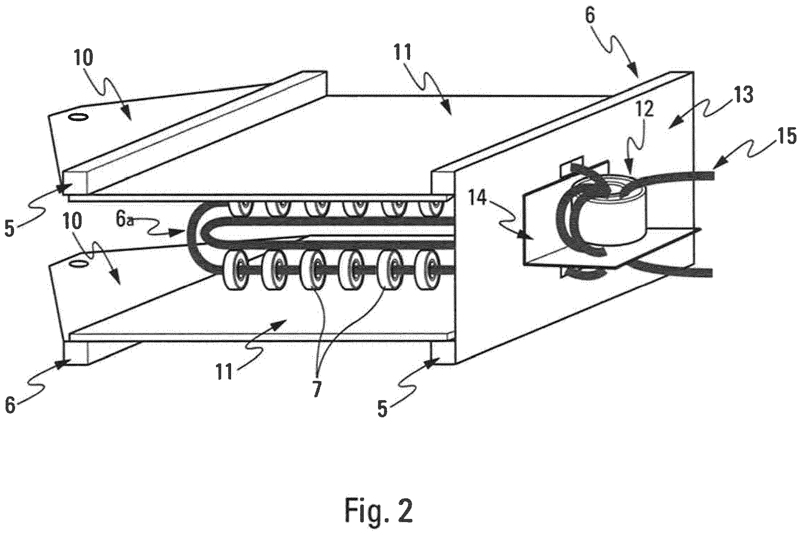

La figure 2 présente un assemblage de cartes électroniques 11 en série. Ce montage mécanique est fait pour réduire la boucle et minimiser le champ magnétique. Les composants de la carte électronique 11 du dessus ont la tête en bas, contrairement à la carte électronique 11 du bas.

Selon une particularité, le transformateur d'impulsion comprend en outre :
- un tore 7 de ferrite non isolé électriquement et comprenant une ouverture,
- un câble à haute tension 6a isolé pour former le circuit primaire 6a,
- un premier fil 20 isolé électriquement et bobiné sur le tore 7 de ferrite pour former le premier circuit secondaire,
- un deuxième fil 27 isolé électriquement et bobiné sur le tore 7 de ferrite pour former le deuxième circuit secondaire, et
- un troisième fil 23 non isolé électriquement en contact électrique avec le tore 7 de ferrite, le troisième fil 23 étant connecté à un potentiel électrique sensiblement égal à 0 V.

Ce type de transformateur est généralement appelé transformateur torique.

Le potentiel électrique sensiblement égal à 0 V correspond au potentiel de source des transistors de puissance 9 d'une rangée de la matrice. Chaque rangée correspond à un étage dans lequel les transistors sont mis en parallèle.

Chaque colonne correspond à un montage en série des transistors.

Les tores 7 de ferrites sont non isolés (par exemple, non enduits) afin de permettre la réalisation d'un contact électrique entre le matériau et le potentiel électrique sensiblement égal à 0 V.

En effet, lors de commutation ultra-rapide en tension (c'est-à-dire pour une forte valeur de la dérivée de la tension par rapport au temps ou autrement dit à fort dV/dt), des courants parasites transitent par couplage capacitif du câble à haute tension 6a à la partie comprenant les transistors de puissance 9. Ce couplage capacitif s'effectue entre le câble à haute tension 6a et le dispositif de commande 1 via le tore 7 de ferrite.

Pour éviter que ces courants parasites ne viennent perturber le dispositif de commande 1, le tore 7 de ferrite est référencé au potentiel électrique sensiblement égal à 0 V de l'étage considéré (voir figure 1). Le courant transitera de la borne source des transistors de puissance 9 au tore 7 de ferrite sans venir perturber le dispositif de commande.

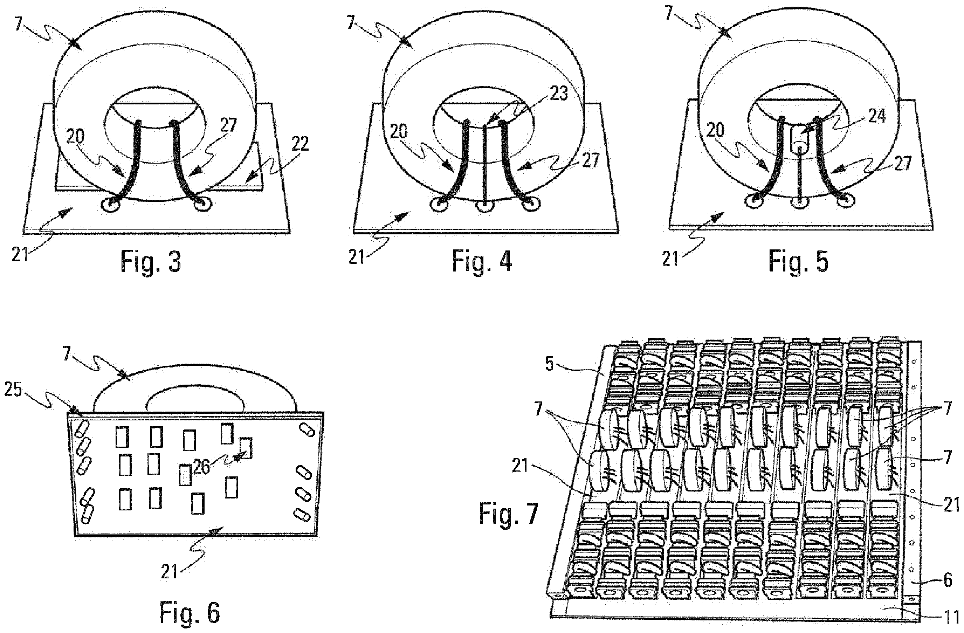

La mise en contact à un potentiel électrique sensiblement égal à 0 V de l'étage considéré des tores 7 de ferrites sur un circuit imprimé 21 d'une carte électronique 11 peut être réalisée par une zone de cuivre 22 étamée sous le tore 7 de ferrite (figure 3) ou par un fil non isolé 23 (figure 4) ou par une résistance de faible valeur 24 donc les pattes en cuivre étamées viendront effectuer la liaison (figure 5). La résistance de faible valeur est le plus souvent utilisée, car son coût est faible.

Les fils isolés (ou strap) 20 réalisent le premier circuit secondaire 20 du transformateur, leurs connexions s'effectuant par leurs pistes du circuit imprimé. Les fils isolés 20 et le fil non isolé 23 ou la résistance 24 participent aussi aux maintiens mécaniques du tore 7 de ferrite sur le circuit imprimé de la carte électronique 21.

De préférence, le dispositif de commande 1 est associé au tore 7 de ferrite par les fils isolés 20 et 27 formant les deux circuits secondaires 20, 27 et de la résistance 24 de liaison de la ferrite à un potentiel électrique sensiblement égal à 0 V de l'étage considéré. Une carte électronique 21 comprenant un circuit imprimé de commande comportant ces différents éléments est réalisée (figure 6). Un circuit imprimé de commande peut être double face ou multicouche 21 (figure 6) avec des plans de masse et un montage des composants du dispositif de commande 1 sous celui-ci permet de garantir une bonne tenue aux perturbations. Ce circuit imprimé de commande est relié à un circuit imprimé de puissance comprenant les transistors de puissance 9 via des connecteurs 25. Ces connecteurs 25 peuvent être du type HE13/HE14.

La réalisation de ce dispositif de commande 1 sous forme de carte électronique 21 permet de tester séparément celui-ci avant de l'intégrer sur le circuit imprimé de puissance 11. Ce dispositif de commande 1 permet aussi de densifier le circuit imprimé de puissance et donc de minimiser la taille globale du commutateur.

De préférence, la connexion au circuit imprimé de puissance se fait sur toute la largeur de la carte électronique 11 afin d'assurer une répartition homogène des courants sur chaque transistor de puissance 9 mis en parallèle.

Selon un mode de réalisation, des plaques conductrices 10 (par exemple, en cuivre) de forme triangulaire assurent la liaison entre le câble d'entrée et la carte électronique 11 en permettant d'assurer cette homogénéité de courant, tout en minimisant l'inductance de connexion. Ces plaques conductrices 10 se montent via des vis sur des barreaux en cuivre 5 et 6 qui eux-mêmes sont vissés sur le circuit imprimé. La figure 2 montre un exemple de deux cartes électroniques 11 connectées en série. Une plaque conductrice 13 de la largeur de la carte électronique 11 assure la liaison électrique entre les deux circuits imprimés de puissance. Un premier barreau 5 sert de borne drain du commutateur. Un deuxième barreau 6 sert de borne source du commutateur. Par exemple, les barreaux 5 et 6 sont, au moins en partie, en cuivre étamé ou en laiton. La plaque conductrice 13 assure la liaison entre la borne drain 5 du commutateur de la carte électronique du bas 11 et la borne source 6 du commutateur de la carte électronique du haut 11 en considérant que le bas de la figure 2 correspond au bas du commutateur.

Le système étant modulaire, chaque circuit imprimé est par lieu même un commutateur élémentaire.

Par exemple, l'utilisation de matrice de transistors de puissance 9 en carbure de silicium de type SIC, ou en Nitrure de Gallium de type GaN demande des inductances série faible afin d'obtenir des temps de commutation sur le courant faible. Une faible inductance série garantie aussi une minimisation des surtensions à l'ouverture.

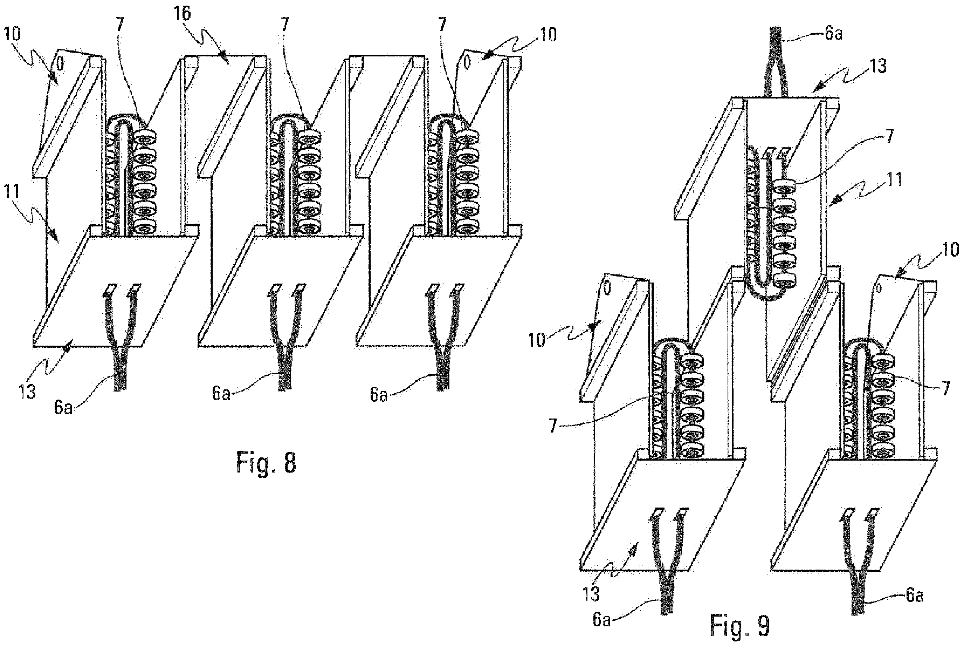

Les figures 8 et 9 montrent la disposition des modules en accordéon afin d'avoir une longueur du commutateur réduite par rapport à une mise en ligne des modules. Les plaques de connexion 13 et 16 permettent la connexion des circuits imprimés de puissance, en série.

Le commutateur permet par la mise en matrice, la réalisation d'un commutateur robuste. La perte d'un transistor de puissance 9 ne doit pas empêcher ceux restant d'être correctement piloté. Une résistance de protection 8 (voir figure 11) mise en série avec chaque borne grille de transistor de puissance 9 permet le pilotage, en cas de défaillance en circuit ouvert drain-source et/ou de court-circuit grille-source d'un transistor de puissance 9 de commander les autres transistors de puissance 9 de la ligne. Cette résistance de protection 8 permet aussi un équilibrage des courants de charge ou de décharge de la borne grille des transistors de puissance 9 mis en parallèle.

Pour la défaillance en court-circuit d'une rangée de transistors de puissance 9, la mise en série des transformateurs formés par le câble haute tension 6a (figure 1), le tore 7 de ferrite et les spires secondaires bobinées sur ce tore 7, assure le fonctionnement des autres rangées de la matrice malgré la défaillance d'une ou plusieurs rangées.

La défaillance d'un transistor de puissance 9 en court-circuit se traduit par une rangée de la matrice en court-circuit. Ceci entraîne une baisse de la tenue en tension du commutateur. En prévoyant, des lignes supplémentaires nous augmentons la fiabilité du commutateur, car un transistor de puissance 9 défaillant en court-circuit n'engendrera pas la panne globale du commutateur.

Par exemple, s'il est prévu, par module de puissance, des lignes supplémentaires, la fiabilité globale est d'autant plus augmentée, car le nombre de rangées pouvant être perdu sera égal au nombre de modules de puissance mis en série, multiplié par le nombre de rangées supplémentaires prévu par module élémentaire qui est généralement de un ou deux.

Il existe donc une marge de sécurité en tension par module de puissance qui déterminera la fiabilité globale du commutateur.

Selon une configuration, chaque module de puissance se présente comme indiqué à la figure 1.

Les transistors de puissance 9 sont montés sous forme de matrice avec N transistors par rangée (mise en parallèle) et M transistors par colonne (mise en série). Ces transistors de puissance 9 sont représentés par simplification sous la forme d'IGBT, mais ceux-ci peuvent être n'importe quel composant à grille isolée (MOSFET, IGBT, SIC, GaN).

De même, nous garderons par simplification l'appellation des bornes des IGBT :
- Borne collecteur qui correspond à la borne drain dans le cas de transistor MOSFET, SIC ou GaN,
- Borne émetteur qui correspond à la borne source dans le cas de transistor MOSFET, SIC ou GaN.

Il n'y a pas d'ambiguïté pour la borne grille.

Chaque transistor est protégé en surtension entre la borne collecteur et la borne émetteur par un dispositif d'écrêtage 4. Il n'y a pas obligatoirement un dispositif d'écrêtage par transistor.

Ce dispositif d'écrêtage pourra être :
- une diode Zener monodirectionnelle ou bidirectionnelle,
- plusieurs diodes Zener monodirectionnelle ou bidirectionnelle placées en série,
- une varistance ou plusieurs varistances en série.

Le signal de commande est appliqué sur les grilles des transistors de puissance au travers de la résistance de protection 8 de faible valeur.

Les transistors de puissance 9 mis en parallèle, avec une même commande de grille, peuvent pendant les phases d'ouverture et/ou de fermeture se mettre à osciller (résonance). Des circuits d'amortissement 2 et 3 permettent d'atténuer ses oscillations. Ces circuits d'amortissements 2 et 3 peuvent être composés de composants passifs, tels que des résistances, des condensateurs ou des inductances, et/ou actifs tels que des diodes ou des transistors.

Les barreaux 5 et 6 permettent une liaison mécanique et électrique entre le circuit imprimé de puissance et des plaques conductrices 10 et 13 (voir figure 2).

De préférence, ces barreaux 5 et 6 sont de la largeur de la carte électronique 11 afin d'homogénéiser la répartition des courants dans tous les transistors de puissance 9.

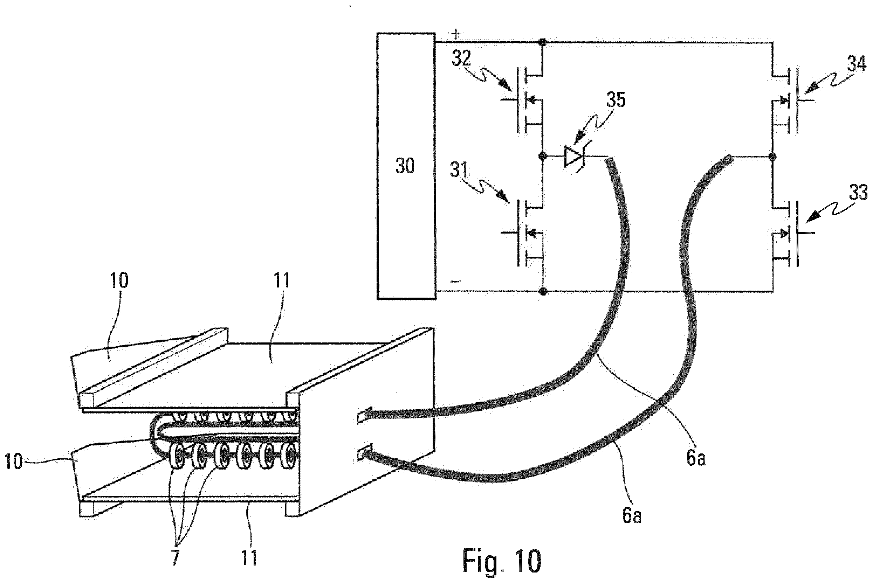

Selon un mode de réalisation, les signaux de commande sont envoyés à partir d'une carte driver (figure 10) comportant une alimentation 30 et un pont complet à transistor 31, 32, 33 et 34. Au vu des temps de conduction très courts (de l'ordre de 500 ns) pouvant être demandés aux transistors, ceux-ci sont, par exemple, du type MOSFET, SIC ou GaN. De façon non limitative, la tension de l'alimentation 30 est comprise entre 100 V et 1000 V suivant le nombre de rangées à commander par module.

Suivant l'ordre Marche ou Arrêt désiré, la tension est générée par la commande simultanée de deux transistors suivie d'une phase de roue libre 31 et 33. Par exemple, un Ordre de Marche correspond à une impulsion positive 32 et 33. Un Ordre d'Arrêt correspond à une impulsion négative 31 et 34. La phase de roue libre sert à minimiser l'inversion de tension en sortie des transformateurs d'impulsions.

La figure 10 propose une commande directe dans les transformateurs d'impulsion des modules de puissance.

Cette commande peut être aussi indirecte en passant par des transformateurs intermédiaires 12 (figure 2).

L'application, sur un commutateur ouvert (donc en phase d'arrêt), de fortes variations de tension avec un dV/dt important entre sa borne collecteur et sa borne émetteur, impose d'avoir une tension négative sur chaque transistor de puissance 9.

La fréquence de ces pulses négative peut varier en fonction de la tension négative désirée sur les grilles des transistors de puissance 9. Une diode Zener 35 de faible valeur d'écrêtage permet d'effectuer la roue libre en imposant une tension aux transformateurs toriques afin d'avoir une tension moyenne nulle à leurs bornes. Ces impulsions négatives transitent sur le câble haute tension 6a.

Elles peuvent être appliquées, tout d'abord à des tores intermédiaires 12 comme représenté sur la figure 2 ou directement sur le câble haute tension 6a formant le circuit primaire des transformateurs des modules commutateur.

Ces impulsions se retrouvent sur les deux circuits secondaires 20 et 27 du transformateur d'impulsion. De façon non limitative, le nombre de spires des circuits secondaires est compris entre 1 et 5.

Selon un mode de réalisation, le module de mémorisation 60 comprend un condensateur de mémorisation 62 connecté en parallèle au deuxième circuit secondaire 27.

Le condensateur de mémorisation 62 est :
- apte à être chargé négativement lorsque le circuit primaire 6a émet une impulsion de tension négative inférieure à une première valeur de tension prédéterminée et
- apte à être chargé positivement lorsque le circuit primaire 6a émet une impulsion de tension positive supérieure à une deuxième valeur de tension prédéterminée.

Le condensateur de mémorisation 62 possède une première borne connectée à une borne grille d'un transistor à effet de champ à canal P 65 du dispositif de commande 1 et à une borne grille d'un transistor à effet de champ à canal N 64 du dispositif de commande 1. Le condensateur de mémorisation 62 possède en outre une deuxième borne connectée à une borne source du transistor à effet de champ à canal N 64 et à une borne source du transistor à effet de champ à canal P 65.

Le premier circuit secondaire 20 possède une première branche connectée à une borne drain du transistor à effet de champ à canal N 64 et à une borne drain du transistor à effet de champ à canal P 65 et une deuxième branche connectée aux bornes émetteur des transistors à grille isolée 9 de la matrice. La première branche comprend une première diode redresseuse 69 et la deuxième branche comprenant une deuxième diode redresseuse 71.

La borne source du transistor à effet de champ à canal N 64 et la borne source du transistor à effet de champ à canal P 65 sont connectées aux bornes de grille des transistors de puissance 9 de la matrice,

L'étage amplificateur 64, 65 peut comprendre le transistor à effet de champ à canal N 64 et le transistor à effet de champ à canal P 65.

La première borne du condensateur de mémorisation 62 est connectée au module de renforcement de la commande.

Selon un mode de réalisation, le module de mémorisation 60 comprend en outre une unité d'interrupteur 60a comprenant des composants actifs tels que des diodes, des diodes Zener ou des transistors et passifs tels que des résistances ou des condensateurs. Mais, elle peut faire aussi l'objet d'une réalisation dans un circuit intégré. Sa fonction est d'assurer une mémorisation de la commande par la charge du condensateur de mémorisation 62 :
- en tension positive si l'impulsion de tension Vin entre les deux branches du deuxième circuit secondaire 27 est positive et supérieure à la première valeur prédéterminée,
- en tension négative si l'impulsion de tension Vin entre les deux branches du deuxième circuit secondaire 27 est négative et inférieure à la deuxième valeur prédéterminée.

De façon non limitative, la première valeur de tension prédéterminée est comprise dans une plage de valeur allant de 3 V à 20 V. De préférence, la première valeur de tension prédéterminée est sensiblement égale à 10 V. La deuxième valeur de tension prédéterminée est comprise dans une plage de valeur allant de -3 V à -20 V. De préférence, la deuxième valeur de tension prédéterminée est sensiblement égale à -10 V.

Selon un mode de réalisation, le dispositif de commande 1 comprend également :
- un premier condensateur de filtrage 72 monté en parallèle avec la diode de décharge 73,
- un deuxième condensateur de filtrage 70 connecté entre la borne drain du transistor à effet de champ à canal N 64 et un potentiel électrique sensiblement égal au 0 V de la rangée de la matrice considérée.

De préférence, le module de mémorisation 60 comprend en outre une unité d'écrêtage 63 montée en parallèle avec le condensateur de mémorisation 62.

De plus, le dispositif de commande 1 comprend aussi une première résistance d'amortissement 68 montée sur la première branche du premier circuit secondaire 20, une deuxième résistance d'amortissement 67 connectée à la borne grille du transistor à effet de champ à canal P 65 et une troisième résistance d'amortissement 66 connectée à la borne grille du transistor à effet de champ à canal N 64.

Selon un mode de réalisation, l'unité d'interrupteur 60a comprend au moins un premier interrupteur monodirectionnel en tension et bidirectionnel en courant et un deuxième interrupteur monodirectionnel en tension et bidirectionnel en courant. Le premier interrupteur est connecté à la première borne du condensateur de mémorisation 62. Le deuxième interrupteur est connecté à la deuxième borne du condensateur de mémorisation 62. Le premier interrupteur est apte à établir la connexion entre une première branche du deuxième circuit secondaire 27 et la première borne du condensateur de mémorisation 62 lorsque le circuit primaire 6a émet une impulsion de tension négative inférieure à la première valeur de tension déterminée. Le deuxième interrupteur est apte à établir la connexion entre une deuxième branche du deuxième circuit secondaire 27 et la deuxième borne du condensateur de mémorisation 62 lorsque le circuit primaire 6a émet une impulsion de tension positive de valeur absolue supérieure à la deuxième valeur de tension déterminée.

Selon un mode de réalisation, une première diode 82 est placée en antiparallèle du premier interrupteur et une deuxième diode 83 en série. Suivant le type de transistor utilisé pour réaliser la fonction d'interrupteur, les diodes 82 et 83 peuvent ne pas être montées.

Le condensateur de mémorisation 62 se décharge très lentement. L'impulsion de commande positive ou négative peut être renouvelée afin d'avoir des temps de fermeture (en phase de marche) ou d'ouverture (en phase d'arrêt) très longs.

De préférence, la tension sur le condensateur de mémorisation 62 est écrêtée par l'unité d'écrêtage 63 pouvant être formée par une diode Zener bidirectionnelle ou par deux diodes Zener en série tête-bêche, afin de protéger les transistors 64 et 65 en limitant leur tension de grille.

Si l'impulsion est négative et suffisamment élevée pour une bonne immunité aux parasites, l'unité d'interrupteur 60a charge le condensateur de mémorisation 62 avec une valeur négative. Cette tension négative est appliquée entre la borne grille et la borne source du transistor à canal P 65 qui devient passant. La tension négative est appliquée entre la borne grille et la borne source du transistor à canal N 64 qui le bloque. Les transistors 64 et 65 sont des transistors à effet de champ afin de minimiser la décharge du condensateur de mémorisation 62.

Pour une impulsion négative, le premier circuit secondaire 20 (figure 11) est redressé par la diode 71 et filtré par le condensateur de filtrage 72. La première résistance d'amortissement 68 limite le courant. Le condensateur de filtrage 72 est chargé à une tension négative de l'ordre d'une quinzaine de volts.

La tension négative sur le condensateur de filtrage 72 est appliquée aux bornes grilles des transistors de puissance 9, le transistor 65 étant fermé. Une tension négative est appliquée sur les transistors de puissance 9.

Les résistances d'amortissement 66 et 67 limitent et amortissent les courants de commande des transistors 64 et 65.

La diode de décharge 73 permet un déchargement des condensateurs des bornes grilles des transistors de puissance 9 en l'absence de tension négative sur le condensateur de filtrage 72.

Pour enclencher le commutateur, une impulsion positive est envoyée.

Ainsi, si l'impulsion de commande est positive et suffisamment élevée pour avoir une bonne immunité contre les parasites, la tension sur le condensateur de mémorisation 62 est positive. Cette tension positive est appliquée entre la borne drain et la borne source du transistor à canal N 64 qui devient passant. La tension positive est appliquée entre la borne drain et la borne source du transistor à canal P 65 qui le bloque.

Le premier circuit secondaire 20 (figure 11) est redressé par la première diode redresseuse 69 et filtré par le deuxième condensateur de filtrage 70. La résistance d'amortissement 68 limite le courant. Le deuxième condensateur de filtrage 70 est chargé à une tension positive de l'ordre d'une quinzaine de volt.

La tension positive en sortie de la première diode redresseuse 69 est appliquée aux bornes grilles des transistors de puissance 9, le transistor 64 étant fermé. Les transistors de puissance 9 deviennent alors passants.

Les condensateurs de filtrage 70 et 72 peuvent être optionnels. En effet les capacités des bornes grilles des transistors de puissance 9 peuvent suffirent, à eux seuls, à filtrer l'impulsion de la commande.

L'enclenchement très rapide des transistors de puissance 9 peut nécessiter des courants de grille pouvant difficilement être emmenés par le transformateur d'impulsion pouvant être lié, par exemple, à un problème au sujet des tailles des transformateurs d'impulsion toriques et des courants dans le câble haute tension 6a de commande. Cela peut nécessiter l'utilisation d'un module de renforcement de la commande 50.

Selon un mode de réalisation, le module de renforcement 50 comprend :
- une unité d'amplification 51 montée en série avec la première borne du condensateur de mémorisation 62,
- un transistor à effet de champ à canal N 52 possédant une borne grille connectée à l'unité d'amplification 51, une borne source connectée aux bornes grilles des transistors de puissance 9, une borne drain connectée aux bornes drain des transistors de puissance 9,
- une première diode 53 possédant une cathode connectée à la borne drain du transistor à effet de champ à canal N 52 et une anode connectée aux bornes drain des transistors de puissance 9,
- un condensateur de réserve 56 connecté dont une première borne est connectée à la borne drain du transistor à effet de champ à canal N 52 et dont une deuxième borne connectée à un potentiel électrique sensiblement égal à 0 V de l'étage considéré,
- une deuxième diode 55 et une résistance 54 montées en parallèle, la deuxième diode 55 possédant une cathode connectée à la borne drain du transistor à effet de champ à canal N 52 et une anode connectée à la première borne du condensateur de réserve 56,
- une diode écrêteuse 57 possédant une anode connectée à un potentiel électrique sensiblement égal à 0 V de l'étage considéré et une cathode connectée à la première borne du condensateur de réserve 56.

La commande du transistor 52 peut venir directement du condensateur de mémorisation 62. Elle peut être amplifiée par l'unité d'amplification 51, afin d'obtenir des temps de commutation encore plus bref. Si les temps de commutation des transistors de puissance 9 sont très rapides, l'énergie emmenée par le circuit comprenant le transistor 52 et la première diode 53 peut être insuffisante, la tension collecteur-émetteur étant abaissée trop rapidement. Il en est de même si la tension collecteur-émetteur du commutateur est faible avant l'enclenchement. Une réserve d'énergie est donc préférable. Le condensateur de réserve 56 se charge à la tension collecteur-émetteur d'une ligne du commutateur au travers de la première diode 53 et de la résistance 54. La diode écrêteuse 57 (par exemple, une diode Zener unidirectionnelle ou bidirectionnelle) protège le condensateur de réserve 56.

L'enclenchement du transistor 52 par une impulsion positive transitant dans le dispositif de commande, décharge le condensateur de réserve 56 dans les bornes grilles des transistors de puissance 9 renforçant ainsi le courant de commande, ce qui permet un enclenchement ultra-rapide.

De préférence, les bornes grilles des transistors de puissance 9 sont protégées par des diodes Zener bidirectionnelles 80.

Comme décrit ci-dessus, une rangée de transistors de puissance 9 peut comprendre un premier dispositif de commande 1 connecté à une rangée et un deuxième dispositif de commande 1 connecté à une rangée. Ce commutateur utilise donc la redondance du dispositif de commande 1.

La figure 1 présente une mise en redondance des dispositifs de commande 1. Sur la figure 1, les bornes de chaque dispositif de commande 1 nommées :
- Dr pour la borne driver ou drain,
- G pour la borne Grille,
- E pour la borne Émetteur
sont reliées entre elles, respectivement.

Si un ordre de marche par une impulsion positive est reçu sur un dispositif de commande 1 et non l'autre dispositif de commande 1, les condensateurs de mémorisation 62 des deux dispositifs de commande 1 respectifs sont chargés positivement.

Le dispositif de commande 1 n'ayant pas reçu l'ordre de marche, les interrupteurs de l'unité d'interrupteur 60a restent ouverts. Cependant, cela n'influe pas sur le dispositif de commande 1 ayant reçu l'ordre de marche. Le commutateur peut donc s'enclencher.

Si un dispositif de commande 1 reçoit un ordre d'enclenchement par une impulsion positive et l'autre dispositif de commande 1 reçoit un ordre d'ouverture par une impulsion négative, les condensateurs de mémorisation 62 sont toujours chargés positivement. Si nécessaire, un commutateur avec commande redondante avec priorité à l'ouverture peut être réalisé en positionnant une résistance 81 en série avec le deuxième interrupteur. En effet, la résistance 81 connectée en série avec la deuxième diode 83 (figure 11) dans le module de mémorisation 60 ne permet pas une tension négative sur les condensateurs de mémorisation 62, l'impédance sur le module imposant une tension positive étant plus faible. Une priorité à la fermeture est donc donnée.

La figure 7 présente un exemple de circuit imprimé de puissance comportant ces circuits de commandes en redondance. Ces circuits de commande sont placés au centre du circuit imprimé afin d'avoir une meilleure répartition des signaux de commande sur les transistors de puissance.

La présente description détaille différents modes de réalisation en référence à des figures et/ou des caractéristiques techniques. L'homme du métier comprendra que les diverses caractéristiques techniques des divers modes peuvent être combinées entre elles pour obtenir d'autres modes de réalisation, à moins que l'inverse ne soit explicitement mentionné ou que ces caractéristiques techniques ne soient incompatibles. De même, une caractéristique technique d'un mode de réalisation peut être isolée des autres caractéristiques techniques de ce mode de réalisation à moins que l'inverse ne soit mentionné. Dans la présente description, de nombreux détails spécifiques sont fournis à titre illustratif et nullement limitatif, de façon à détailler précisément l'invention. L'homme de métier comprendra cependant que l'invention peut être réalisée en l'absence d'un ou plusieurs de ces détails spécifiques ou avec des variantes. À d'autres occasions, certains aspects ne sont pas détaillés de façon à éviter d'obscurcir et alourdir la présente description et l'homme de métier comprendra que des moyens divers et variés pourront être utilisés et que l'invention n'est pas limitée aux seuls exemples décrits.

Il doit être évident pour les personnes versées dans l'art que la présente invention permet des modes de réalisation sous de nombreuses autres formes spécifiques sans l'éloigner du domaine d'application de l'invention comme revendiqué. Par conséquent, les présents modes de réalisation doivent être considérés à titre d'illustration, mais peuvent être modifiés dans le domaine défini par la portée des revendications jointes, et l'invention ne doit pas être limitée aux détails donnés ci-dessus.

## Revendications

1. Commutateur ultra-rapide à haute tension, comprenant :
- au moins une matrice de transistors de puissance à grille isolée (9) contenant au moins une rangée de transistors de puissance (9) montés en parallèle ou au moins une colonne de transistors de puissance (9) montés en série,
- pour chaque rangée de transistors de puissance (9), un premier dispositif de commande (1) étant connecté à la rangée de transistors de puissance (9), le premier dispositif de commande (1) étant apte à commander les transistors de puissance (9) de la rangée correspondante,
- pour chaque premier dispositif de commande (1), au moins un transformateur d'impulsion comprenant un circuit primaire (6a) de commande apte à émettre une commande, un premier circuit secondaire (20) et un deuxième circuit secondaire (27), et au moins un module de renforcement de la commande (50) apte à renforcer la commande émise par le circuit primaire (6a) par l'intermédiaire du deuxième circuit secondaire (27),
le ou les premiers dispositifs de commande (1) incluant un module de mémorisation (60) de la commande apte à mémoriser la commande émise par le circuit primaire (6a) par l'intermédiaire du deuxième circuit secondaire (27), chacun des transistors de puissance (9) présentant une borne drain et une borne source, le module de renforcement (50) étant apte à piloter les transistors de puissance (9) en utilisant une tension présente entre la borne drain et la borne source de chacun des transistors de puissance (9), le premier circuit secondaire (20) étant apte à fournir l'énergie nécessaire au fonctionnement d'un étage d'amplification (64, 65) du premier dispositif de commande (1), l'étage d'amplification (64, 65), présent entre le module de mémorisation (60) et les transistors de puissance (9), étant apte à amplifier la commande mémorisée par le module de mémorisation (60) afin de piloter les transistors de puissance (9).

2. Commutateur selon la revendication 1,
**caractérisé en ce qu'**il comprend en outre :
- pour chaque rangée de transistors de puissance (9), un deuxième dispositif de commande connecté à la rangée de transistors de puissance (9), le deuxième dispositif de commande (1) étant apte à commander les transistors de puissance (9),
- pour chaque deuxième dispositif de commande (1), au moins un transformateur d'impulsion comprenant un circuit primaire (6a) de commande apte à émettre une commande, un premier circuit secondaire (20) et un deuxième circuit secondaire (27), et au moins un module de renforcement de la commande (50) apte à renforcer la commande émise par le circuit primaire (6a) par l'intermédiaire du deuxième circuit secondaire (27),
- le ou les deuxièmes dispositifs de commande (1) incluant un module de mémorisation apte à mémoriser la commande émise par le circuit primaire (6a) par l'intermédiaire du deuxième circuit secondaire (27).

3. Commutateur selon l'une quelconque des revendications 1 ou 2, **caractérisé en ce que** le module de mémorisation (60) comprend un condensateur de mémorisation (62) connecté en parallèle au deuxième circuit secondaire (27), le condensateur de mémorisation (62) étant :
- apte à être chargé négativement lorsque le circuit primaire (6a) émet une impulsion de tension négative inférieure à une première valeur de tension déterminée et
- apte à être chargé positivement lorsque le circuit primaire (6a) émet une impulsion de tension positive supérieure à une deuxième valeur de tension déterminée,
le condensateur de mémorisation (62) possédant une première borne connectée à une borne grille d'un transistor à effet de champ à canal P (65) et à une borne grille d'un transistor à effet de champ à canal N (64), le condensateur de mémorisation (62) possédant en outre une deuxième borne connectée à une borne source du transistor à effet de champ à canal N (64) et à une borne source du transistor à effet de champ à canal P (65),
le premier circuit secondaire (20) possédant une première branche connectée à une borne drain du transistor à effet de champ à canal N (64) et à une borne drain du transistor à effet de champ à canal P (65) et une deuxième branche connectée aux bornes émetteur des transistors à grille isolée (9) de la matrice, la première branche comprenant une première diode redresseuse (69) et la deuxième branche comprenant une deuxième diode redresseuse (71),
la borne source du transistor à effet de champ à canal N et la borne source du transistor à effet de champ à canal P étant connectées aux bornes de grille des transistors à grille isolée (9) de la matrice,
la première borne du condensateur de mémorisation étant connectée au module de renforcement de la commande.

4. Commutateur selon la revendication 3,
**caractérisé en ce que** le module de mémorisation (60) comprend en outre une unité d'interrupteur (60a) comprenant au moins un premier et un deuxième interrupteur monodirectionnel en tension et bidirectionnel en courant, le premier interrupteur étant connecté à la première borne du condensateur de mémorisation (62), le deuxième interrupteur étant connecté à la deuxième borne du condensateur de mémorisation (62), le premier interrupteur étant apte à établir la connexion entre une première branche du deuxième circuit secondaire (27) et la première borne du condensateur de mémorisation (62) lorsque le circuit primaire (6a) émet une impulsion de tension négative inférieure à la première valeur de tension déterminée, le deuxième interrupteur étant apte à établir la connexion entre une deuxième branche du deuxième circuit secondaire (27) et la deuxième borne du condensateur de mémorisation (62) lorsque le circuit primaire (6a) émet une impulsion de tension positive de valeur absolue supérieure à la deuxième valeur de tension déterminée.

5. Commutateur selon l'une quelconque des revendications 3 à 4, **caractérisé en ce qu'**il comprend une diode de décharge (73) possédant une anode connectée à la borne drain du transistor à effet de champ à canal P (65) et une cathode connectée à la deuxième branche du premier circuit secondaire (20).

6. Commutateur selon l'une quelconque des revendications 1 à 5, **caractérisé en ce que** le transformateur d'impulsion comprend en outre :
- un tore (7) de ferrite non isolé électriquement et comprenant une ouverture,
- un câble à haute tension isolé (6a) pour former le circuit primaire,
- un premier fil (20) isolé électriquement et bobiné sur le tore (7) pour former le premier circuit secondaire,
- un deuxième fil (27) isolé électriquement et bobiné sur le tore (7) pour former le deuxième circuit secondaire, et
- un troisième fil (23) non isolé électriquement en contact électrique avec le tore (7), le troisième fil étant connecté à un potentiel électrique sensiblement égal à 0 Vde la rangée considérée.

7. Commutateur selon l'une quelconque des revendications 3 à 6, **caractérisé en ce que** le module de renforcement (50) comprend :
- une unité d'amplification (51), une entrée de l'unité d'amplification (51) étant connectée à la première borne du condensateur de mémorisation (62),
- un transistor à effet de champ à canal N (52) possédant une borne grille connectée à une sortie de l'unité d'amplification (51), une borne source connectée aux bornes grilles des transistors de puissance (9), une borne drain connectée aux bornes drain des transistors de puissance (9),
- une première diode (53) possédant une cathode connectée à la borne drain du transistor à effet de champ à canal N (52) et une anode connectée aux bornes drain des transistors de puissance (9),
- un condensateur de réserve (56) connecté dont une première borne est connectée à la borne drain du transistor à effet de champ à canal N (52) et dont une deuxième borne connectée à un potentiel électrique sensiblement égal à 0 V,
- une deuxième diode (55) et une résistance (54) montées en parallèle, la deuxième diode (55) possédant une cathode connectée à la borne drain du transistor à effet de champ à canal N (52) et une anode connectée à la première borne du condensateur de réserve (56),
- une diode écrêteuse (57) possédant une anode connectée à un potentiel électrique sensiblement égal à 0 V et une cathode connectée à la première borne du condensateur de réserve (56).

8. Commutateur selon l'une quelconque des revendications 5 ou 7, **caractérisé en ce que** le dispositif de commande (1) comprend en outre :
- un premier condensateur de filtrage (72) monté en parallèle avec la diode de décharge (73),
- un deuxième condensateur de filtrage (70) connecté entre la borne drain du transistor à effet de champ à canal N (64) et un potentiel électrique sensiblement égal à 0 V.

9. Commutateur selon l'une quelconque des revendications 3 à 8, **caractérisé en ce que** le module de mémorisation (60) comprend en outre une unité d'écrêtage (63) montée en parallèle avec le condensateur de mémorisation (62).

10. Commutateur selon l'une quelconque des revendications 4 à 7, **caractérisé en ce que** le dispositif de commande (1) comprend en outre une première résistance d'amortissement (68) montée sur la première branche du premier circuit secondaire (20), une deuxième résistance d'amortissement (67) connectée à la borne grille du transistor à effet de champ à canal P (65) et une troisième résistance d'amortissement (66) connectée à la borne grille du transistor à effet de champ à canal N (64).

## Patentansprüche

1. Extrem schneller Hochspannungsschalter, umfassend:
- mindestens eine Matrix mit Leistungstransistoren mit isoliertem Gate (9), die mindestens eine Reihe von parallel geschalteten Leistungstransistoren (9) oder mindestens eine Spalte von in Reihe geschalteten Leistungstransistoren (9) enthält,
- für jede Reihe von Leistungstransistoren (9) eine erste Steuervorrichtung (1), die mit der Reihe von Leistungstransistoren (9) verbunden ist, wobei die erste Steuervorrichtung (1) dazu geeignet ist, die Leistungstransistoren (9) der entsprechenden Reihe zu steuern,
- für jede erste Steuervorrichtung (1) mindestens einen Impulstransformator, der eine Primärschaltung (6a), die dazu geeignet ist, einen Befehl zu senden, eine erste Sekundärschaltung (20) und eine zweite Sekundärschaltung (27) umfasst, und mindestens ein Befehlsverstärkungsmodul (50), das dazu geeignet ist, den von der Primärschaltung (6a) über die zweite Sekundärschaltung (27) gesendeten Befehl zu verstärken,
wobei die erste Vorrichtung oder die ersten Steuervorrichtungen (1) ein Speichermodul (60) der Steuerung einschließt/einschließen, das dazu geeignet ist, den von der Primärschaltung (6a) über die zweite Sekundärschaltung (27) gesendeten Befehl zu speichern, wobei jeder der Leistungstransistoren (9) einen Drain-Anschluss und einen Source-Anschluss aufweist, wobei das Verstärkungsmodul (50) dazu geeignet ist, die Leistungstransistoren (9) unter Verwendung einer zwischen dem Drain-Anschluss und dem Source-Anschluss jedes der Leistungstransistoren (9) vorhandenen Spannung zu steuern, wobei die erste Sekundärschaltung (20) dazu geeignet ist, die zum Betrieb einer Verstärkerstufe (64, 65) der ersten Steuervorrichtung (1) erforderliche Energie bereitzustellen, wobei die Verstärkerstufe (64, 65), die sich zwischen dem Speichermodul (60) und den Leistungstransistoren (9) befindet, dazu geeignet ist, die von dem Speichermodul (60) gespeicherte Steuerung zu verstärken, um die Leistungstransistoren (9) zu steuern.

2. Schalter nach Anspruch 1, **dadurch gekennzeichnet, dass** er weiter umfasst:
- für jede Reihe von Leistungstransistoren (9) eine zweite Steuervorrichtung, die mit der Reihe von Leistungstransistoren (9) verbunden ist, wobei die zweite Steuervorrichtung (1) dazu geeignet ist, die Leistungstransistoren (9) zu steuern,
- für jede zweite Steuervorrichtung (1) mindestens einen Impulstransformator, der eine Primärsteuerschaltung (6a), die dazu geeignet ist, einen Befehl zu senden, eine ersten Sekundärschaltung (20) und eine zweite Sekundärschaltung (27) umfasst, und mindestens ein Befehlsverstärkungsmodul (50), das dazu geeignet ist, den von der Primärschaltung (6a) über die zweite Sekundärschaltung (27) gesendeten Befehl zu verstärken,
- wobei die zweite Steuervorrichtung oder die zweiten Steuervorrichtungen (1) ein Speichermodul einschließt/einschließen, das dazu geeignet ist, den von der Primärschaltung (6a) über die zweite Sekundärschaltung (27) gesendeten Befehl zu speichern.

3. Schalter nach einem der Ansprüche 1 oder 2,
**dadurch gekennzeichnet, dass** das Speichermodul (60) einen Speicherkondensator (62) umfasst, der parallel zu der zweiten Sekundärschaltung (27) geschaltet ist, wobei der Speicherkondensator (62):
- dazu geeignet ist, negativ geladen zu werden, wenn die Primärschaltung (6a) einen negativen Spannungsimpuls unterhalb eines ersten bestimmten Spannungswertes aussendet und
- dazu geeignet ist, positiv geladen zu werden, wenn die Primärschaltung (6a) einen positiven Spannungsimpuls oberhalb eines bestimmten zweiten Spannungswertes aussendet,
wobei der Speicherkondensator (62) einen ersten Anschluss besitzt, der mit einem Gate-Anschluss eines P-Kanal-Feldeffekttransistors (65) und mit einem Gate-Anschluss eines N-Kanal-Feldeffekttransistors (64) verbunden ist, wobei der Speicherkondensator (62) weiter einen zweiten Anschluss aufweist, der mit einem Source-Anschluss des N-Kanal-Feldeffekttransistors (64) und mit einem Source-Anschluss des P-Kanal-Feldeffekttransistors (65) verbunden ist,
wobei die erste Sekundärschaltung (20) einen ersten Zweig, der mit einem Drain-Anschluss des N-Kanal-Feldeffekttransistors (64) und mit einem Drain-Anschluss des P-Kanal-Feldeffekttransistors (65) verbunden ist, und einen zweiten Zweig besitzt, der mit Emitter-Anschlüssen der Transistoren mit isoliertem Gate (9) der Matrix verbunden ist, wobei der erste Zweig eine erste Gleichrichterdiode (69) und der zweite Zweig eine zweite Gleichrichterdiode (71) umfasst,
wobei der Source-Anschluss des N-Kanal-Feldeffekttransistors und der Source-Anschluss des P-Kanal-Feldeffekttransistors mit den Gate-Anschlüssen der Transistoren mit isoliertem Gate (9) der Matrix verbunden sind,
wobei der erste Anschluss des Speicherkondensators mit dem Befehlsverstärkungsmodul verbunden ist.

4. Schalter nach Anspruch 3,
**dadurch gekennzeichnet, dass** das Speichermodul (60) weiter eine Schalteinheit (60a) umfasst, die mindestens einen ersten und einen zweiten Schalter umfasst, die in Bezug auf die Spannung monodirektional und in Bezug auf den Strom bidirektional sind, wobei der erste Schalter mit dem ersten Anschluss des Speicherkondensators (62) verbunden ist, der zweite Schalter mit dem zweiten Anschluss des Speicherkondensators (62) verbunden ist, wobei der erste Schalter dazu geeignet ist, die Verbindung zwischen einem ersten Zweig der zweiten Sekundärschaltung (27) und dem ersten Anschluss des Speicherkondensators (62) herzustellen, wenn die Primärschaltung (6a) einen negativen Spannungsimpuls unterhalb des ersten bestimmten Spannungswertes aussendet, wobei der zweite Schalter dazu geeignet ist, die Verbindung zwischen einem zweiten Zweig der zweiten Sekundärschaltung (27) und dem zweiten Anschluss des Speicherkondensators (62) herzustellen, wenn die Primärschaltung (6a) einen positiven Spannungsimpuls oberhalb des bestimmten zweiten Spannungswertes aussendet.

5. Schalter nach einem der Ansprüche 3 bis 4,
**dadurch gekennzeichnet, dass** er eine Entladungsdiode (73) umfasst, deren Anode mit dem Drain-Anschluss des P-Kanal-Feldeffekttransistors (65) und deren Kathode mit dem zweiten Zweig der ersten Sekundärschaltung (20) verbunden ist.

6. Schalter nach einem der Ansprüche 1 bis 5,
**dadurch gekennzeichnet, dass** der Impulstransformator weiter umfasst:
- einen Ferritkern (7), der nicht elektrisch isoliert ist und eine Öffnung umfasst,
- ein isoliertes Hochspannungskabel (6a) zur Bildung der Primärschaltung,
- einen ersten elektrisch isolierten Draht (20), der auf den Kern (7) zur Bildung der ersten Sekundärschaltung gewickelt ist,
- einen zweiten elektrisch isolierten Draht (27), der auf den Kern (7) zur Bildung der zweiten Sekundärschaltung gewickelt ist, und
- einen dritten, nicht elektrisch isolierten Draht (23), der in elektrischem Kontakt mit dem Kern (7) steht, wobei der dritte Draht mit einem elektrischen Potential verbunden ist, das im Wesentlichen gleich 0 V der betreffenden Reihe ist.

7. Schalter nach einem der Ansprüche 3 bis 6,
**dadurch gekennzeichnet, dass** das Verstärkungsmodul (50) umfasst:
- eine Verstärkereinheit (51), wobei ein Eingang der Verstärkereinheit (51) mit dem ersten Anschluss des Speicherkondensators (62) verbunden ist,
- einen N-Kanal-Feldeffekttransistor (52), der einen mit einem Ausgang der Verstärkereinheit (51) verbundenen Gate-Anschluss, einen mit den Gate-Anschlüssen der Leistungstransistoren (9) verbundenen Source-Anschluss und einen mit den Drain-Anschlüssen der Leistungstransistoren (9) verbundenen Drain-Anschluss besitzt,
- eine erste Diode (53), die eine mit dem Drain-Anschluss des N-Kanal-Feldeffekttransistors (52) verbundene Kathode und eine mit den Drain-Anschlüssen der Leistungstransistoren (9) verbundene Anode besitzt,
- einen angeschlossenen Reservekondensator (56), dessen erster Anschluss mit dem Drain-Anschluss des N-Kanal-Feldeffekttransistors (52) verbunden ist und dessen zweiter Anschluss mit einem elektrischen Potential verbunden ist, das im Wesentlichen gleich 0 V ist,
- eine zweite Diode (55) und einen Widerstand (54), die parallel geschaltet sind, wobei die zweite Diode (55) eine Kathode besitzt, die mit dem Drain-Anschluss des N-Kanal-Feldeffekttransistors (52) verbunden ist, und eine Anode, die mit dem ersten Anschluss des Reservekondensators (56) verbunden ist,
- eine Begrenzerdiode (57), die eine mit einem elektrischen Potential von im Wesentlichen gleich 0 V verbundene Anode und eine mit dem ersten Anschluss des Reservekondensators (56) verbundene Kathode besitzt.

8. Schalter nach einem der Ansprüche 5 oder 7,
**dadurch gekennzeichnet, dass** die Steuervorrichtung (1) weiter umfasst:
- einen ersten Filterkondensator (72), der parallel zur Entladungsdiode (73) geschaltet ist,
- einen zweiten Filterkondensator (70), der zwischen dem Drain-Anschluss des N-Kanal-Feldeffekttransistors (64) und einem elektrischen Potenzial von im Wesentlichen gleich 0 V angeschlossen ist.

9. Schalter nach einem der Ansprüche 3 bis 8,
**dadurch gekennzeichnet, dass** das Speichermodul (60) weiter eine Begrenzungseinheit (63) umfasst, die parallel zu dem Speicherkondensator (62) geschaltet ist.

10. Schalter nach einem der Ansprüche 4 bis 7,
**dadurch gekennzeichnet, dass** die Steuervorrichtung (1) weiter einen ersten Dämpfungswiderstand (68), der auf dem ersten Zweig der ersten Sekundärschaltung (20) geschaltet ist, einen zweiten Dämpfungswiderstand (67), der mit dem Gate-Anschluss des P-Kanal-Feldeffekttransistors (65) verbunden ist, und einen dritten Dämpfungswiderstand (66), der mit dem Gate-Anschluss des N-Kanal-Feldeffekttransistors (64) verbunden ist, umfasst.

## Claims

1. High-speed high-voltage switch, comprising:
- at least one insulated gate power transistor matrix (9) containing at least one row of power transistors (9) connected in parallel or at least one column of power transistors (9) connected in series,
- for each row of power transistors (9), a first control device (1) being connected to the row of power transistors (9), the first control device (1) being adapted to control the power transistors (9) of the corresponding row,
- for each first control device (1), at least one pulse transformer comprising a primary control circuit (6a) adapted to emit a command, a first secondary circuit (20) and a second secondary circuit (27), and at least one command reinforcement module (50) adapted to reinforce the command emitted by the primary circuit (6a) via the second secondary circuit (27),
the first control device or devices (1) including a control storage module (60) adapted to store the command emitted from the primary circuit (6a) via the second secondary circuit (27), each of the power transistors (9) having a drain terminal and a source terminal, the reinforcement module (50) being adapted to drive the power transistors (9) using a voltage present between the drain terminal and the source terminal of each of the power transistors (9), the first secondary circuit (20) being adapted to supply power for operating an amplifying stage (64, 65) of the first control device (1), the amplifying stage (64, 65), present between the storage module (60) and the power transistors (9), being adapted to amplify the command stored by the storage module (60) to drive the power transistors (9).

2. Switch according to claim 1, **characterised in that** it further comprises:
- for each row of power transistors (9), a second control device connected to the row of power transistors (9), the second control device (1) being adapted to control the power transistors (9),
- for each second control device (1), at least one pulse transformer comprising a primary control circuit (6a) adapted to emit a command, a first secondary circuit (20) and a second secondary circuit (27), and at least one command reinforcement module (50) adapted to reinforce the command emitted by the primary circuit (6a) via the second secondary circuit (27),
- the second control device or devices (1) including a storage module adapted to store the command emitted by the primary circuit (6a) via the second secondary circuit (27).

3. Switch according to any one of claims 1 or 2,
**characterised in that** the storage module (60) comprises a storage capacitor (62) connected in parallel to the second secondary circuit (27), the storage capacitor (62) being:
- able to be negatively charged when the primary circuit (6a) emits a negative voltage pulse below a first determined voltage value and
- able to be positively charged when the primary circuit (6a) emits a positive voltage pulse greater than a second determined voltage value,
the storage capacitor (62) having a first terminal connected to a gate terminal of a P-channel field effect transistor (65) and a gate terminal of an N-channel field effect transistor (64), the storage capacitor (62) further having a second terminal connected to a source terminal of the N-channel field effect transistor (64) and a source terminal of the P-channel field effect transistor (65),
the first secondary circuit (20) having a first branch connected to a drain terminal of the N-channel field effect transistor (64) and a drain terminal of the P-channel field effect transistor (65) and a second branch connected to emitter terminals of the insulated gate transistors (9) of the matrix, the first branch comprising a first rectifier diode (69) and the second branch comprising a second rectifier diode (71)
the source terminal of the N-channel field effect transistor and the source terminal of the P-channel field effect transistor being connected to the gate terminals of the insulated gate transistors (9) of the matrix, the first terminal of the storage capacitor being connected to the control reinforcement module.

4. Switch according to claim 3,
**characterized in that** the storage module (60) further comprises a switch unit (60a) comprising at least a first and a second switch monodirectional in voltage and bidirectional in current, the first switch being connected to the first terminal of the storage capacitor (62), the second switch being connected to the second terminal of the storage capacitor (62), the first switch being capable of establishing the connection between a first branch of the second secondary circuit (27) and the first terminal of the storage capacitor (62) when the primary circuit (6a) emits a negative voltage pulse lower than the first determined voltage value, the second switch being capable of establishing the connection between a second branch of the second secondary circuit (27) and the second terminal of the storage capacitor (62) when the primary circuit emits a positive voltage pulse with an absolute value greater than the second determined voltage value.

5. Switch according to any one of claims 3 to 4,
**characterised in that** it comprises a discharge diode (73) having an anode connected to the drain terminal of the P-channel field effect transistor (65) and a cathode connected to the second branch of the first secondary circuit (20).

6. Switch according to any one of claims 1 to 5, **characterised in that** the pulse transformer further comprises:
- an electrically non-insulated ferrite toroid (7) comprising an opening,
- an insulated high voltage cable (6a) to form the primary circuit,
- a first electrically insulated wire (20) wound on the toroid (7) to form the first secondary circuit,
- a second electrically insulated wire (27) wound on the toroid (7) to form the second secondary circuit, and
- a third, non-electrically insulated wire (23) in electrical contact with the toroid (7), the third wire being connected to an electrical potential substantially equal to 0 V of the row under consideration.

7. Switch according to any one of claims 3 to 6,
**characterised in that** the reinforcement module (50) comprises:
- an amplification unit (51), an input of the amplification unit (51) being connected to the first terminal of the storage capacitor (62),
- an N-channel field effect transistor (52) having a gate terminal connected to an output of the amplification unit (51), a source terminal connected to the gate terminals of the power transistors (9), a drain terminal connected to the drain terminals of the power transistors (9),
- a first diode (53) having a cathode connected to the drain terminal of the N-channel field effect transistor (52) and an anode connected to the drain terminals of the power transistors (9),
- a spare capacitor (56) connected with a first terminal connected to the drain terminal of the N-channel field effect transistor (52) and with a second terminal connected to an electrical potential substantially equal to 0 V,
- a second diode (55) and a resistor (54) connected in parallel, the second diode (55) having a cathode connected to the drain terminal of the N-channel field effect transistor (52) and an anode connected to the first terminal of the spare capacitor (56),
- a clipper diode (57) having an anode connected to an electrical potential substantially equal to 0 V and a cathode connected to the first terminal of the spare capacitor (56).

8. Switch according to any one of claims 5 or 7,
**characterised in that** the control device (1) further comprises:
- a first filter capacitor (72) connected in parallel with the discharge diode (73),
- a second filter capacitor (70) connected between the drain terminal of the N-channel field effect transistor (64) and an electrical potential substantially equal to 0 V.

9. Switch according to any one of claims 3 to 8,
**characterised in that** the storage module (60) further comprises a clipping unit (63) connected in parallel with the storage capacitor (62).

10. Switch according to any one of claims 4 to 7,
**characterised in that** the control device (1) further comprises a first damping resistor (68) connected to the first branch of the first secondary circuit (20), a second damping resistor (67) connected to the gate terminal of the P-channel field effect transistor (65) and a third damping resistor (66) connected to the gate terminal of the N-channel field effect transistor (64).
